# EUROPEAN PATENT APPLICATION

(11) **EP 4 386 834 A1**
(43) Date of publication of application: **19.06.2024**
(21) Application number: 23216920.1
(22) Date of filing: 14.12.2023
(51) Int. Cl.: H01L 23/48, H01L 21/768, H01L 25/18, H01L 25/065

(54) **SEMICONDUCTOR CHIP AND METHOD OF MANUFACTURING THE SAME**

(30) Priority: 16.12.2022 KR 20220177327
(71) Applicant: Samsung Electronics Co., Ltd., Suwon-si, Gyeonggi-do 16677 (KR)
(72) Inventor: SON, Jungil, 16677 Suwon-si (KR); KIM, Taeyoon, 16677 Suwon-si (KR); KU, Kunwoo, 16677 Suwon-si (KR); MOON, Sungwook, 16677 Suwon-si (KR)
(74) Representative: Marks & Clerk LLP

(57) **Abstract**

The present disclosure provides a semiconductor chip. In some embodiments, a semiconductor chip includes a semiconductor substrate, an integrated circuit layer formed on the semiconductor substrate, and a plurality of metal wiring layers sequentially formed on the semiconductor substrate and the integrated circuit layer. The semiconductor chip further includes a first through via structure bundle extending in a vertical direction from a first metal wiring layer of the plurality of metal wiring layers toward the semiconductor substrate and penetrating through the semiconductor substrate. The semiconductor chip further includes a second through via structure bundle spaced apart from the first through via structure bundle, extending in the vertical direction from a second metal wiring layer of the plurality of metal wiring layers toward the semiconductor substrate, and penetrating through the semiconductor substrate.

## Description

### BACKGROUND

### 1. Field

The present disclosure relates generally to a semiconductor chip and a method of manufacturing the same, and more particularly, to a semiconductor chip including a through silicon via (TSV) and a method of manufacturing the same.

### 2. Description of Related Art

Recently, as 3-dimensional (3D) semiconductor packages in which a plurality of semiconductor chips is mounted in a semiconductor package may be being actively developed, silicon through electrodes that may penetrate through a substrate and/or a die to form an electrical connection in a vertical direction may be used. Thus, there exists a need for further improvements in semiconductor packages, as the need for 3D semiconductor packages may be constrained by an electrical and/or mechanical reliability of a connection structure between a plurality of semiconductor chips. Improvements are presented herein. These improvements may also be applicable to other semiconductor technologies and the standards that employ these technologies.

### SUMMARY

The present disclosure provides a semiconductor chip in which capacitances and resistances of different regions may be adjusted differently, and which includes through via structures having different shapes to prevent deterioration of electrical performance of a surrounding integrated circuit layer, and a method of manufacturing the same.

The technical goals to be achieved by the present disclosure may not be limited to the technical goals mentioned herein, and other technical goals may be clearly understood by one of ordinary skill in the art from the following descriptions.

According to an aspect of the present disclosure, a semiconductor chip is provided. The semiconductor chip includes a semiconductor substrate, an integrated circuit layer formed on the semiconductor substrate, and a plurality of metal wiring layers sequentially formed on the semiconductor substrate and the integrated circuit layer. The semiconductor chip further includes a first through via structure bundle extending in a vertical direction from a first metal wiring layer of the plurality of metal wiring layers toward the semiconductor substrate and penetrating through the semiconductor substrate. The semiconductor chip further includes a second through via structure bundle spaced apart from the first through via structure bundle, extending in the vertical direction from a second metal wiring layer of the plurality of metal wiring layers toward the semiconductor substrate, and penetrating through the semiconductor substrate.

According to an aspect of the present disclosure, a semiconductor chip is provided. The semiconductor chip includes a semiconductor substrate having a first surface and a second surface facing each other. The semiconductor chip further includes a front end level layer formed on the first surface of the semiconductor substrate and including an integrated circuit layer. The semiconductor chip further includes a back end level layer electrically connected to the integrated circuit layer on the front end level layer and including a plurality of metal wiring layers. The semiconductor chip further includes a first through via structure bundle extending in a vertical direction from a first metal wiring layer of the plurality of metal wiring layers toward the semiconductor substrate and penetrating through the front end level layer, the first surface of the semiconductor substrate, and the second surface of the semiconductor substrate. The semiconductor chip further includes a second through via structure bundle spaced apart from the first through via structure bundle, extending in the vertical direction from a second metal wiring layer of the plurality of metal wiring layers toward the semiconductor substrate, and penetrating through at least a part of the back end level layer, the front end level layer, the first surface of the semiconductor substrate, and the second surface of the semiconductor substrate.

According to an aspect of the present disclosure, a semiconductor chip is provided. The semiconductor chip includes a semiconductor substrate, and a front end level layer including an integrated circuit layer formed on the semiconductor substrate, an interlayer insulation layer insulating the integrated circuit layer, and a contact plug layer electrically connected to the integrated circuit layer within the interlayer insulation layer. The semiconductor chip further includes a back end level layer formed on the front end level layer and including a plurality of metal wiring layers sequentially and electrically connected to the contact plug layer, wiring insulation layers insulating between the plurality of metal wiring layers, and a plurality of wiring vias interconnecting the plurality of metal wiring layers within the wiring insulation layers. The semiconductor chip further includes a first through via structure bundle extending in a vertical direction from a first metal wiring layer of the plurality of metal wiring layers toward the semiconductor substrate and penetrating through the interlayer insulation layer and the semiconductor substrate. The semiconductor chip further includes a second through via structure bundle spaced apart from the first through via structure bundle, extending in the vertical direction from a second metal wiring layer of the plurality of metal wiring layers toward the semiconductor substrate, and penetrating through the wiring insulation layers, the interlayer insulation layer, and the semiconductor substrate. The first through via structure bundle is formed in a first keep out zone located on a first side of the integrated circuit layer, and the second through via structure bundle is formed in a second keep out zone located on a second side of the integrated circuit layer.

At least some of the above and other features of the invention are set out in the claims.

Additional aspects may be set forth in part in the description which follows and, in part, may be apparent from the description, and/or may be learned by practice of the presented embodiments.

### BRIEF DESCRIPTION OF DRAWINGS

The above and other aspects, features, and advantages of certain embodiments of the present disclosure may be more apparent from the following description taken in conjunction with the accompanying drawings, in which:
FIG. 1 is a cross-sectional view of a semiconductor chip, according to an embodiment;
FIG. 2 is an enlarged view of a portion CX1 and a portion CX2 of FIG. 1, according to an embodiment;
FIG. 3 is a plan view for describing the arrangement relationship of the through via structure of FIG. 1, according to an embodiment;
FIGS. 4 to 6 are plan views for describing the arrangement relationships between through via structures of a semiconductor chip, according to various embodiments;
FIGS. 7 to 9 are diagrams showing a semiconductor chip, according to various embodiments;
FIG. 10 is a flowchart showing a method of manufacturing a semiconductor chip, according to an embodiment;
FIGS. 11 to 16 are cross-sectional views showing a method of manufacturing a semiconductor chip according to a process sequence, according to an embodiment; and
FIGS. 17 and 18 are block diagrams showing semiconductor packages including semiconductor chips, according to various embodiments.

### DETAILED DESCRIPTION

The following description with reference to the accompanying drawings is provided to assist in a comprehensive understanding of embodiments of the present disclosure defined by the claims and their equivalents. Various specific details are included to assist in understanding, but these details are considered to be examples only. Therefore, those of ordinary skill in the art may recognize that various changes and modifications of the embodiments described herein can be made without departing from the scope of the disclosure. In addition, descriptions of well-known functions and structures may be omitted for clarity and conciseness.

With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of possible combinations of the items enumerated together in a corresponding one of the phrases. As used herein, such terms as "1 st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wired), wirelessly, or via a third element.

It is to be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

The terms "upper," "middle", "lower" may refer to relative positions along a particular direction (e.g. a vertical direction). Various directions (e.g. vertical direction, horizontal direction, etc.) may be defined relative to the structure of the devices described herein. It will be appreciated that these directions do not necessarily imply any particular orientation of the device in use. The terms "upper," "middle", "lower", etc. may be replaced with terms, such as "first," "second," third" to be used to describe relative positions of elements. The terms "first," "second," third" may be used to describe various elements but the elements are not limited by the terms and a "first element" may be referred to as a "second element". Alternatively or additionally, the terms "first", "second", "third", etc. may be used to distinguish components from each other and do not limit the present disclosure. For example, the terms "first", "second", "third", etc. may not necessarily involve an order or a numerical meaning of any form.

Reference throughout the present disclosure to "one embodiment," "an embodiment," "an example embodiment," or similar language may indicate that a particular feature, structure, or characteristic described in connection with the indicated embodiment is included in at least one embodiment of the present solution. Thus, the phrases "in one embodiment", "in an embodiment," "in an example embodiment," and similar language throughout this disclosure may, but do not necessarily, all refer to the same embodiment.

It is to be understood that the specific order or hierarchy of blocks in the processes/flowcharts disclosed are an illustration of example approaches. Based upon design preferences, it is understood that the specific order or hierarchy of blocks in the processes/flowcharts may be rearranged. Further, some blocks may be combined or omitted. The accompanying claims present elements of the various blocks in a sample order, and are not meant to be limited to the specific order or hierarchy presented.

As used herein, each of the terms "GaAs", "SiGe", "SiN", "SiO", "TiN", and the like may refer to a material made of elements included in each of the terms and is not a chemical formula representing a stoichiometric relationship.

Hereinafter, various embodiments of the present disclosure are described with reference to the accompanying drawings.

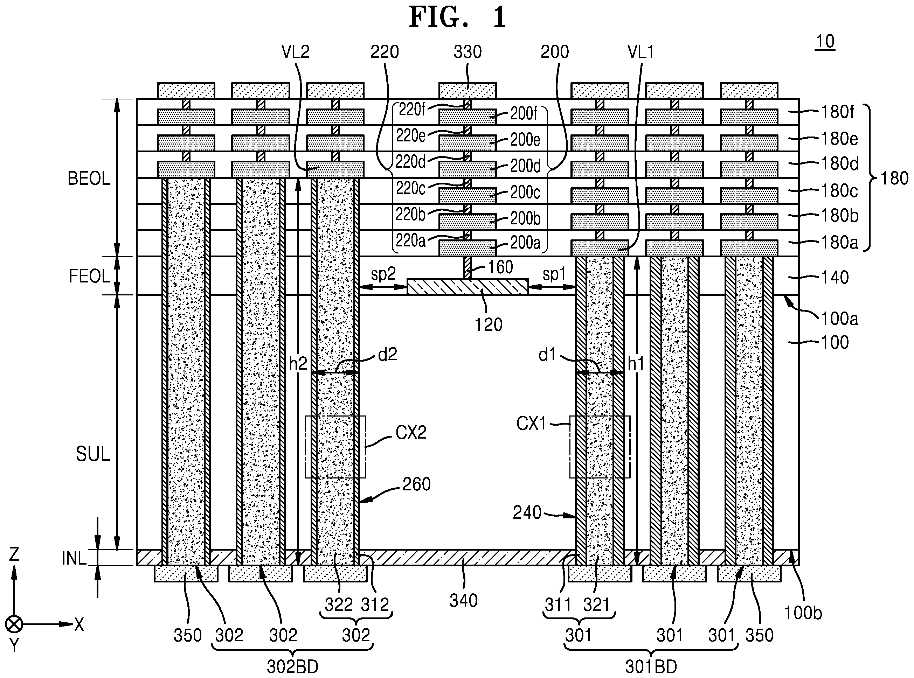

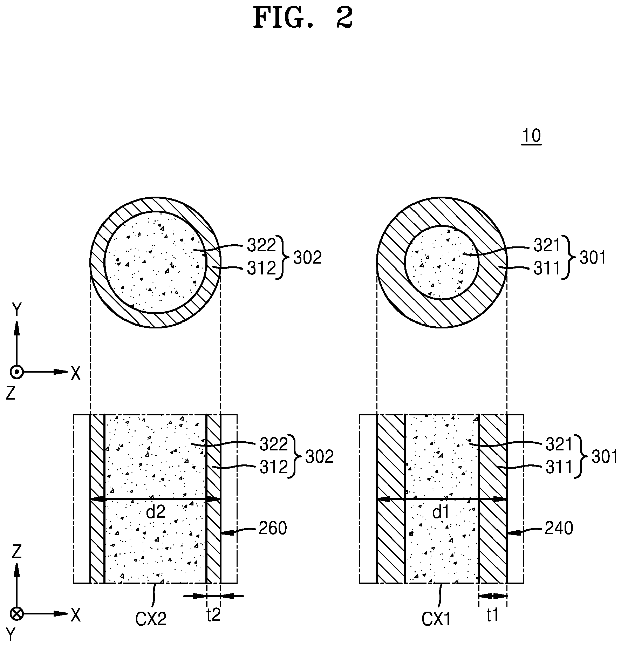

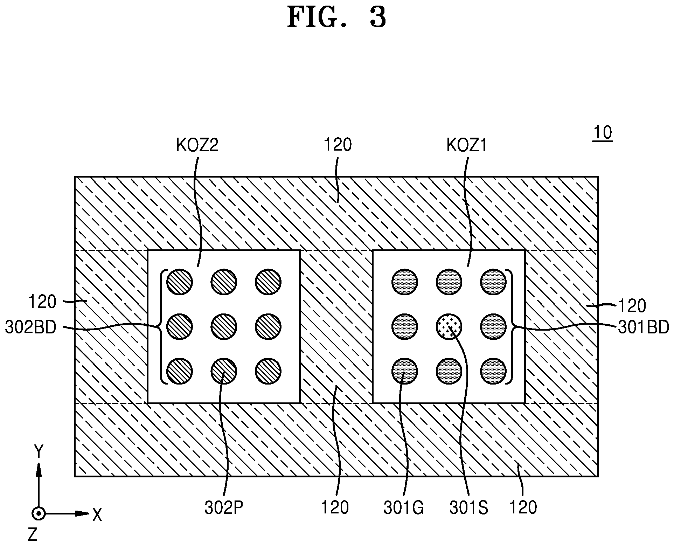

FIG. 1 is a cross-sectional view of a semiconductor chip, according to an embodiment. FIG. 2 is an enlarged view of a portion CX1 and a portion CX2 of FIG. 1, according to an embodiment. FIG. 3 is a plan view for describing the arrangement relationship of the through via structure of FIG. 1, according to an embodiment.

Referring to FIGS. 1 to 3 together, a semiconductor chip 10, according to an embodiment, may include a first bundle 301BD of first through via structures 301 and a second bundle 302BD of second through via structures 302, which may penetrate through a semiconductor substrate 100.

The semiconductor substrate 100 may include a semiconductor material, such as, but not limited to, a group IV semiconductor, a group III-V compound semiconductor, and a group II-VI oxide semiconductor. For example, the group IV semiconductor may include, but not be limited to, silicon (Si), germanium (Ge), or silicon germanium (SiGe). In an embodiment, the semiconductor substrate 100 may by and/or may include a bulk wafer and/or an epitaxial layer. Alternatively or additionally, the semiconductor substrate 100 may be and/or may include a silicon-on-insulator (SOI) substrate, a gallium arsenide (GaAs) substrate, and the like. In an optional or additional embodiment, unit elements necessary for forming semiconductor elements such as various types of active elements and/or passive elements may be formed on the semiconductor substrate 100.

Alternatively or additionally, the semiconductor substrate 100 may be and/or may include a substrate level layer SUL. As shown in FIG. 1, the semiconductor substrate 100 may include a first surface 100a and a second surface 100b facing the first surface 100a. In an embodiment, the first surface 100a may be referred to as an active surface and/or a top surface. Alternatively or additionally, the second surface 100b may be referred to as an inactive surface and/or a bottom surface.

The semiconductor chip 10 may include an integrated circuit layer 120. In an embodiment, the integrated circuit layer 120 may be formed on the first surface 100a of the semiconductor substrate 100. For example, the integrated circuit layer 120 may include circuit elements such as, but not limited to, transistors, capacitors, and resistors. Depending on the structure of the integrated circuit layer 120 and/or on design constraints, the semiconductor chip 10 may function as a memory device and/or a logic device. For example, the memory device may include, but not be limited to, a dynamic random access memory (DRAM), a static random access memory (SRAM), a flash memory, an electrically erasable programmable read-only memory (EEPROM), a phase-change random access memory (PRAM), a magneto-resistive random access memory (MRAM), a resistive random access memory (RRAM), and the like.

In an embodiment, a region below a portion of the first surface 100a of the semiconductor substrate 100 on which the integrated circuit layer 120 is formed may be an active region. Alternatively or additionally, a region below a portion of the first surface 100a of the semiconductor substrate 100 on which the integrated circuit layer 120 is not formed may be an inactive region. For example, the active region may include an impurity-doped region formed below the first surface 100a of the semiconductor substrate 100 (e.g., a source/drain region and/or a well region). Alternatively or additionally, a device isolation region may be formed below the first surface 100a of the semiconductor substrate 100.

In an embodiment, an interlayer insulation layer 140 may be formed on the semiconductor substrate 100 and the integrated circuit layer 120. The interlayer insulation layer 140 may include, but not be limited to, silicon oxide (SiO). In an optional or additional embodiment, a contact plug layer 160 that may be electrically connected to the integrated circuit layer 120 may be formed in the interlayer insulation layer 140. The contact plug layer 160 may be and/or may include a metal layer, such as, but not limited to, a tungsten (W) layer.

The integrated circuit layer 120, the interlayer insulation layer 140, and the contact plug layer 160 formed on the semiconductor substrate 100 may constitute a front end level layer FEOL. The front end level layer FEOL may be referred to as a front end of line in terms of a manufacturing process.

In an embodiment, the semiconductor chip 10 may include metal wiring layers 200. The metal wiring layers 200 may be and/or may include metal layers, such as, but not limited to, copper (Cu) layers, aluminum (Al) layers, and tungsten (W) layers. In an optional or additional embodiment, the metal wiring layers 200 may be formed on the semiconductor substrate 100 and the integrated circuit layer 120. Alternatively or additionally, the metal wiring layers 200 may be sequentially and/or electrically connected to each other. For example, the metal wiring layers 200 may include a first metal wiring layer 200a, a second metal wiring layer 200b, a third metal wiring layer 200c, a fourth metal wiring layer 200d, a fifth metal wiring layer 200e, and a sixth metal wiring layer 200f. In an embodiment, the sixth metal wiring layer 200f may be referred to as the uppermost metal wiring layer.

Although FIG. 1 illustrates six (6) wiring layers (e.g., first to sixth metal wiring layers 200a to 200f), the present disclosure is not limited in this regard. For example, first to n-th metal wiring layers, where n is an integer greater than zero (0), may be sequentially formed on the semiconductor substrate 100 and the integrated circuit layer 120, without departing from the scope of the present disclosure. In such an example, a first metal wiring layer may be referred to as the lowermost metal wiring layer, and an n-th metal wiring layer may be referred to as the uppermost metal wiring layer.

The semiconductor chip 10 may include wiring insulation layers 180. In an embodiment, the wiring insulation layers 180 may insulate between the metal wiring layers 200. The wiring insulation layers 180 may be and/or may include, but not be limited to, silicon oxide (SiO) and silicon nitride (SiN). For example, the wiring insulation layers 180 may include a first wiring insulation layer 180a, a second wiring insulation layer 180b, a third wiring insulation layer 180c, a fourth wiring insulation layer 180d, a fifth wiring insulation layer 180e, and a sixth wiring insulation layer 180f.

The semiconductor chip 10 may include wiring via layers 220. In an embodiment, the wiring via layers 220 may electrically interconnect the metal wiring layers 200 within the wiring insulation layers 180. The wiring via layers 220 may be and/or may include metal layers such as, but not limited to, copper (Cu) layers, aluminum (Al) layers, and tungsten (W) layers. For example, the wiring via layers 220 may include a first wiring via layer 220a, a second wiring via layer 220b, a third wiring via layer 220c, a fourth wiring via layer 220d, a fifth wiring via layer 220e, and a sixth wiring via layer 220f.

In an embodiment, the metal wiring layers 200, the wiring insulation layers 180, and the wiring via layers 220 formed on the front end level layer FEOL may constitute a back end level layer BEOL. In an optional or additional embodiment, the back end level layer BEOL may be referred to as a back end of line in terms of a manufacturing process.

The semiconductor chip 10, according to an embodiment, may include a plurality of first through via structures 301 as the first bundle 301BD. The plurality of first through via structures 301 may include signal transfer via structures 301S and/or ground via structures 301G. Alternatively or additionally, the plurality of first through via structures 301 may be positioned apart from one side of the integrated circuit layer 120 by a first separation distance sp1. According to some embodiments, the first separation distance sp1 may be within a range from several micrometers (µm) to dozens of µm (e.g., 2 to 10 µm ≤ sp1 ≤ 24 to 96 µm).

In an embodiment, a first through via structure 301 may be and/or may include a first through silicon via (TSV) structure. Alternatively or additionally, the first through via structure 301 may have a first diameter d1. The first diameter d1 may be referred to as a first critical dimension. According to some embodiments, the first diameter d1 may be within a range from several µm to dozens of µm (e.g., 2 to 10 µm ≤ d1 ≤ 24 to 96 µm).

Continuing to refer to FIG. 1, the first through via structure 301 may extend in a vertical direction toward the semiconductor substrate 100 from a first via connection level VL1 at which the lowermost metal wiring layer 200 may be located from among the metal wiring layers 200. Alternatively or additionally, the first through via structure 301 may penetrate through the semiconductor substrate 100. In an embodiment, the first via connection level VL1 may correspond to the first metal wiring layer 200a. That is, the first through via structure 301 may penetrate through the interlayer insulation layer 140 constituting the front end level layer FEOL and the semiconductor substrate 100. In an optional or additional embodiment, the first through via structure 301 may have a first vertical length h1. According to some embodiments, the first vertical length h1 may be in the range of dozens of µm. For example, the first vertical length h1 may range from about 50 µm to about 90 µm. As described herein, a vertical direction may be a direction perpendicular to one or both of the first surface 100a of the semiconductor substrate 100 and the second surface 100b of the semiconductor substrate 100. Similarly, a horizontal direction may be a direction parallel to one or both of the first surface 100a of the semiconductor substrate 100 and the second surface 100b of the semiconductor substrate 100. A horizontal plane may be a plane that is perpendicular to the vertical direction (parallel to one or both of the first surface 100a of the semiconductor substrate 100 and the second surface 100b of the semiconductor substrate 100). A vertical level may be a particular position along the vertical direction. A height direction may be defined along the vertical direction (e.g. in a direction from the second surface 100b to the first surface 100a of the semiconductor substrate 100). Features that are located further along this height direction (e.g. further from the second surface 100b) may be considered to be above features that are less far along this height direction (e.g. closer to the second surface 100b). It will be appreciated that these directions are relative to the structure of the semiconductor chip 10 and need not imply any particular orientation of the semiconductor chip 10 in use.

In an embodiment, the first through via structure 301 may include a first via hole 240 formed in the front end level layer FEOL and the semiconductor substrate 100. Alternatively or additionally, the first through via structure 301 may include a first via insulation layer 311 formed on the inner wall of the first via hole 240. In an optional or additional embodiment, the first through via structure 301 may include a first via electrode 321 filling the first via hole 240 on the first via insulation layer 311.

In an embodiment, the first via insulation layer 311 may include a semiconductor material, such as, but not limited to, silicon oxide (SiO) and silicon nitride (SiN). Alternatively or additionally, the first via electrode 321 may be and/or may include a metal layer such as, but not limited to, a copper (Cu) layer, an aluminum (Al) layer, and a tungsten (W) layer. In an optional or additional embodiment, a first via barrier layer may be disposed between the first via insulation layer 311 and the first via electrode 321. In such an embodiment, the first via barrier layer may include a barrier metal layer, such as, but not limited to, a tantalum (Ta) layer and a titanium nitride (TiN) layer. In an embodiment, the first via insulation layer 311 may be conformally formed on the inner wall of the first via hole 240 to a first thickness t1.

The semiconductor chip 10, according to an embodiment, may include a plurality of second through via structures 302 as the second bundle 302BD. The plurality of second through via structures 302 may be referred to as power transmission via structures 302P. In an embodiment, the plurality of second through via structures 302 may be spaced apart from the plurality of first through via structures 301. Alternatively or additionally, the plurality of second through via structures 302 may be spaced apart from the other side of the integrated circuit layer 120 by a second separation distance sp2. According to some embodiments, the second separation distance sp2 may be within a range from several µm to dozens of µm (e.g., 2 to 10 µm ≤ sp2 ≤ 24 to 96 µm).

In an embodiment, a second through via structure 302 may be and/or may include a second TSV structure. Alternatively or additionally, the second through via structure 302 may have a second diameter d2. The second diameter d2 may be referred to as a second critical dimension. According to some embodiments, the second diameter d2 may be within a range from several µm to dozens of µm (e.g., 2 to 10 µm ≤ d2 ≤ 24 to 96 µm). In an optional or additional embodiment, the second diameter d2 of the second through via structure 302 may be substantially similar and/or may be the same as the first diameter d1 of the first through via structure 301.

Continuing to refer to FIG. 1, the second through via structure 302 may extend in a vertical direction toward the semiconductor substrate 100 from a second via connection level VL2, which may correspond to any one of second to sixth metal wiring layers 200b to 200f. Alternatively or additionally, the second through via structure 302 may penetrate through the semiconductor substrate 100. According to some embodiments, the second via connection level VL2 may correspond to the fourth metal wiring layer 200d.

Although the fourth metal wiring layer 200d is described as being used as the second via connection level VL2, the present disclosure is not limited in this regard. For example, any one of the second to sixth metal wiring layers 200b to 200f may be used as the second via connection level VL2 without departing from the scope of the present disclosure. In an embodiment, the second via connection level VL2 may be provided in the middle of the second to sixth metal wiring layers 200b to 200f.

When any one of the second to sixth metal wiring layers 200b to 200f is used as the second via connection level VL2, as compared to the case of using the first metal wiring layer 200a as the second via connection level VL2, the resistance of the second through via structure 302 may be lowered. Consequently, when any one of the second to sixth metal wiring layers 200b to 200f is used as the second via connection level VL2, the resistance of the second through via structure 302 may be adjusted to a desired value (e.g., a resistance value that conforms to one or more design constraints).

The second through via structure 302 may have a second vertical length h2. In an embodiment, the second vertical length h2 may be greater than or equal to the first vertical length h1. According to some embodiments, the second vertical length h2 may be in the range of dozens of µm. For example, the second vertical length h2 may range from about 60 µm to about 150 µm.

In an embodiment, the second via connection level VL2 may be positioned at a different vertical level from the first via connection level VL1 over the semiconductor substrate 100. That is, the first through via structure 301 and the second through via structure 302 may be at different vertical levels from each other.

For example, when the second via connection level VL2 is positioned at a higher vertical level than the first via connection level VL1, the second through via structure 302 may have a relatively low resistance compared to a resistance of the first via connection level VL1. That is, when the second vertical length h2 of the second through via structure 302 is greater than the first vertical length h1 of the first through via structure 301, the second through via structure 302 may connected to the metal wiring layers 200 having a relatively small number of layers, and as a result, the second through via structure 302 may have a low resistance.

In an embodiment, the second through via structure 302 may penetrate through first through third wiring insulation layers 180a, 180b, and 180c constituting a part of the back end level layer BEOL. Alternatively or additionally, the second through via structure 302 may penetrate through the interlayer insulation layer 140 constituting the front end level layer FEOL. In an optional or additional embodiment, the second through via structure 302 may penetrate through the semiconductor substrate 100.

In an embodiment, the second through via structure 302 may include a second via hole 260 formed in the back end level layer BEOL, the front end level layer FEOL, and the semiconductor substrate 100. Alternatively or additionally, the second through via structure 302 may include a second via insulation layer 312 formed on the inner wall of the second via hole 260. In an optional or additional embodiment, the second through via structure 302 may include a second via electrode 322 filling the second via hole 260 on the second via insulation layer 312.

In an embodiment, the second via insulation layer 312 may include a semiconductor material, such as, but not limited to, silicon oxide (SiO) and silicon nitride (SiN). Alternatively or additionally, the second via electrode 322 may be and/or may include a metal layer, such, but not limited to, as a copper (Cu) layer, an aluminum (Al) layer, and a tungsten (W) layer. In an optional or additional embodiment, a second via barrier layer may be disposed between the second via insulation layer 312 and the second via electrode 322. In such an embodiment, the second via barrier layer may by and/or may include a barrier metal layer, such as, but not limited to, a tantalum layer (Ta) and a titanium nitride (TiN) layer. In an embodiment, the second via insulation layer 312 may be conformally formed on the inner wall of the second via hole 260 to a second thickness t2. In such an embodiment, the second thickness t2 of the second via insulation layer 312 may be smaller (e.g., narrower) than the first thickness t1 of the first via insulation layer 311.

The semiconductor chip 10, according to an embodiment, may include an upper pad 330. For example, the upper pad 330 may be formed on the back end level layer BEOL. Alternatively or additionally, the upper pad 330 may be electrically connected to the sixth metal wiring layer 200f (e.g., the uppermost layer of the metal wiring layers 200) through the sixth wiring via layer 220f. In an optional or additional embodiment, solder bumps, which may be and/or may include external connection terminals, may be further formed on the upper pad 330 as needed by one or more design constraints.

In an embodiment, another semiconductor chip (not shown) may be stacked and/or bonded onto the upper pad 330 as needed. In such an embodiment, the upper pad 330 may be insulated by an upper protective insulation layer formed on the sixth wiring insulation layer 180f.

Alternatively or additionally, the semiconductor chip 10 may include a lower pad 350 as needed. The lower pad 350 may be electrically connected to the first through via structure 301 and the second through via structure 302 on the bottom surface of the semiconductor substrate 100. The lower pad 350 may be insulated from the semiconductor substrate 100 by a lower protective insulation layer 340 positioned on the second surface 100b of the semiconductor substrate 100. The lower protective insulation layer 340 may include a semiconductor material, such as, but not limited to, silicon oxide (SiO) and silicon nitride (SiN).

In an embodiment, the lower protective insulation layer 340 may be and/or may include an insulation level layer INL on the second surface 100b of the semiconductor substrate 100. The first through via structure 301 may have the first vertical length h1, which may be measured from the top surface of the lower pad 350 to the first via connection level VL1. The second through via structure 302 may have the second vertical length h2, which may be greater (e.g., longer) than the first vertical length h1, and which may be measured from the top surface of the lower pad 350 to the second via connection level VL2.

In some embodiments, solder bumps, which may be and/or may include external connection terminals, may be further formed on the lower pad 350 as needed. In an optional or additional embodiment, another semiconductor chip (not shown) may be stacked or bonded onto the lower pad 350 as needed.

The arrangement relationship between the integrated circuit layer 120, the first through via structure 301, and the second through via structure 302 is described below.

Referring to FIG. 3, the first bundle 301BD may be formed in a first keep out zone KOZ1 that may be located on one side of the integrated circuit layer 120. The first keep out zone KOZ1 may be and/or may include a region in which the integrated circuit layer 120 is not formed. For example, the integrated circuit layer 120 may be formed around the first keep out zone KOZ1 (e.g. surrounding the first keep out zone KOZ1 in the horizontal plane). As shown in FIG. 3, the arrangement of the plurality of first through via structures 301 included in the first bundle 301BD may be and/or may include a 3×3 structure. However, the present disclosure is not limited thereto. For example, the first bundle 301BD may include the plurality of first through via structures 301 arranged in a 5×5 structure, a 7×7 structure, and the like. According to some embodiments, a signal transfer via structures 301S may be arranged at the center, and the ground via structures 301G may be arranged to surround the signal transfer via structures 301S.

Continuing to refer to FIG. 3, a second bundle 302BD may be formed in a second keep out zone KOZ2 that may be located on the other side of the integrated circuit layer 120 (e.g., opposite to first keep out zone KOZ1). The size of the area of the second keep out zone KOZ2 may be substantially similar and/or may be the same as the size of the area of the first keep out zone KOZ1. The second keep out zone KOZ2 may be and/or may include a region in which the integrated circuit layer 120 is not formed. For example, the integrated circuit layer 120 may be formed around the second keep out zone KOZ2 (e.g. surrounding the second keep out zone KOZ2 in the horizontal plane). As shown in FIG. 3, the arrangement of the plurality of second through via structures 302 included in the second bundle 302BD may be and/or may include a 3×3 structure. However, the present disclosure is not limited thereto. For example, the second bundle 302BD may include the plurality of second through via structures 302 arranged in a 5×5 structure, a 7×7 structure, and the like. According to some embodiments, the second through via structures 302 arranged in the second keep out zone KOZ2 may be the power transmission via structures 302P.

In an embodiment, in the semiconductor chip 10, the first through via structure 301 may be connected to the first via connection level VL1 provided at the bottom of the back end level layer BEOL, the second through via structure 302 may be connected to the second via connection level VL2 provided in the middle of the back end level layer BEOL. That is, the first through via structure 301 and the second through via structure 302 may be at different vertical levels from each other. Consequently, in the semiconductor chip 10, the resistance of the semiconductor chip 10 may be lowered and/or reduced to a desired value by connecting the first through via structure 301 and the second through via structure 302 to different vertical levels of the back end level layer BEOL. In an optional or additional embodiment, by forming the first thickness t1 of the first via insulation layer 311 in the first through via structure 301 to be relatively thick, relatively low capacitance may be implemented. Alternatively or additionally, by forming the second thickness t2 of the second via insulation layer 312 in the second through via structure 302 to be relatively thin, relatively high capacitance and low resistance may be implemented.

In another optional or additional embodiment, the semiconductor chip 10 may obtain a coaxial effect by arranging the signal transfer via structures 301S at the center of the first bundle 301BD and arranging the ground via structures 301G to surround the signal transfer via structures 301S (e.g. surrounding the signal transfer via structures 301S in the horizontal plane). That is, a noise coupling phenomenon may be minimized through signal shielding by arranging the ground via structures 301G to surround the signal transfer via structures 301S.

For example, the semiconductor chip 10, according to the present disclosure, includes through via structures 301 and 302 having different shapes (e.g., vertical lengths and thicknesses of the via insulation layer) as bundles 301BD and 302BD, respectively. Furthermore, since capacitance and resistance may be adjusted by arranging the through via structures 301 and 302 to implement performance suitable for desired applications in different keep out zones KOZ1 and KOZ2, electrical performance deterioration may be potentially reduced and/or prevented.

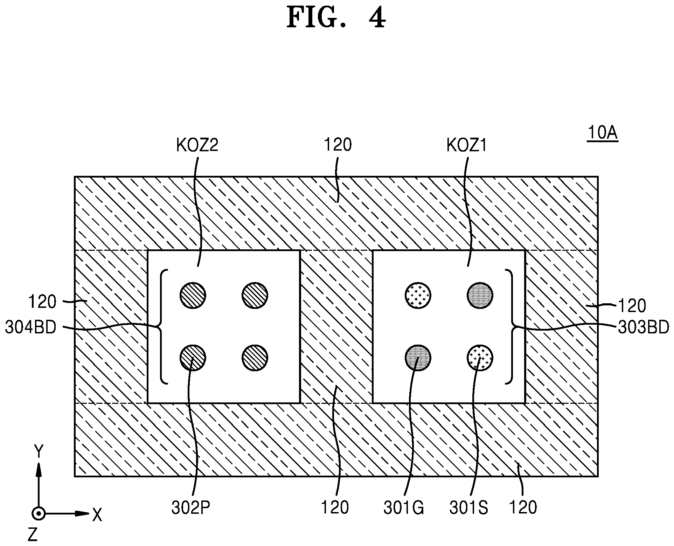

FIGS. 4 to 6 are plan views for describing the arrangement relationships between through via structures of a semiconductor chip, according to various embodiments.

Semiconductor chips 10A, 10B, and 10C of FIGS. 4 to 6 may include and/or may be similar in many respects to at least one of the semiconductor device 10 described above with reference to FIGS. 1 to 3, and may include additional features not mentioned above. Therefore, repeated descriptions of components and/or elements of the semiconductor chip 10 described above may be omitted for the sake of simplicity and brevity.

Referring to FIG. 4, a semiconductor chip 10A, according to an embodiment, may include the first through via structures 301 as a third bundle 303BD and include the second through via structures 302 as a fourth bundle 304BD.

As shown in FIG. 4, the plurality of first through via structures 301 may be configured as the signal transfer via structures 301S and/or the ground via structures 301G in the third bundle 303BD of the semiconductor chip 10A. Alternatively or additionally, the plurality of second through via structures 302 may be configured as the power transmission via structures 302P in the fourth bundle 304BD. In an embodiment, the second through via structure 302 may be spaced apart from the first through via structure 301.

The third bundle 303BD may be formed in the first keep out zone KOZ1 located on one side of the integrated circuit layer 120. As shown in FIG. 4, the arrangement of the plurality of first through via structures 301 included in the third bundle 303BD may be and/or may include a 2×2 structure. However, the present disclosure is not limited thereto. For example, the third bundle 303BD may include the plurality of first through via structures 301 arranged in a 4×4 structure, a 6×6 structure, and the like, without departing from the scope of the present disclosure. According to some embodiments, the signal transfer via structures 301S may be arranged in a diagonal direction, and the ground via structures 301G may be arranged in a diagonal direction opposite to the diagonal direction. The diagonal directions may be horizontal directions (e.g. may be perpendicular to the vertical direction).

In an embodiment, the fourth bundle 304BD may be formed in the second keep out zone KOZ2 that may be located on the other side of the integrated circuit layer 120 (e.g., opposite to first keep out zone KOZ1). The size of the area of the second keep out zone KOZ2 may be substantially similar and/or may be the same as the size of the area of the first keep out zone KOZ1. As shown in FIG. 4, the arrangement of the plurality of second through via structures 302 included in the fourth bundle 304BD may be and/or may include a 2×2 structure. However, the present disclosure is not limited thereto. For example, the fourth bundle 304BD may include the plurality of second through via structures 302 arranged in a 4×4 structure, a 6×6 structure, and the like, without departing from the scope of the present disclosure. According to some embodiments, the second through via structures 302 arranged in the second keep out zone KOZ2 may be the power transmission via structures 302P.

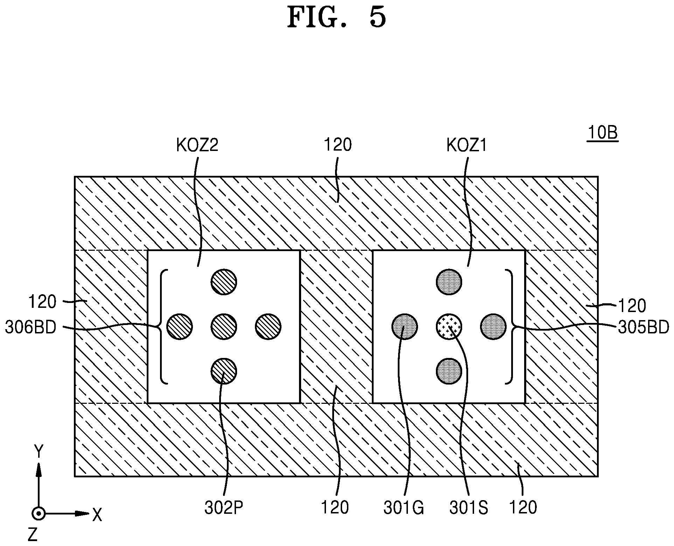

Referring to FIG. 5, a semiconductor chip 10B, according to an embodiment, may include the first through via structures 301 as a fifth bundle 305BD and include the second through via structures 302 as a sixth bundle 306BD.

As shown in FIG. 5, the plurality of first through via structures 301 may be configured as the signal transfer via structures 301S and/or the ground via structures 301G in the fifth bundle 305BD of the semiconductor chip 10B. Alternatively or additionally, the plurality of second through via structures 302 may be configured as the power transmission via structures 302P in the sixth bundle 306BD. In an embodiment, the second through via structure 302 may be spaced apart from the first through via structure 301.

The fifth bundle 305BD may be formed in the first keep out zone KOZ1 located on one side of the integrated circuit layer 120. As shown in FIG. 5, the arrangement of the plurality of first through via structures 301 included in the fifth bundle 305BD may be and/or may include a cross-like structure. However, the present disclosure is not limited thereto. For example, according to some embodiments, a signal transfer via structures 301S may be arranged at the center, and the ground via structures 301G may be arranged around the signal transfer via structures 301S.

In an embodiment, the sixth bundle 306BD may be formed in the second keep out zone KOZ2 that may be located on the other side of the integrated circuit layer 120 (e.g., opposite to first keep out zone KOZ1). The size of the area of the second keep out zone KOZ2 may be substantially similar and/or may be the same as the size of the area of the first keep out zone KOZ1. As shown in FIG. 5, the arrangement of the plurality of second through via structures 302 included in the sixth bundle 306BD may be and/or may include a cross-like structure. However, the present disclosure is not limited thereto. For example, according to some embodiments, the second through via structures 302 arranged in the second keep out zone KOZ2 may be the power transmission via structures 302P.

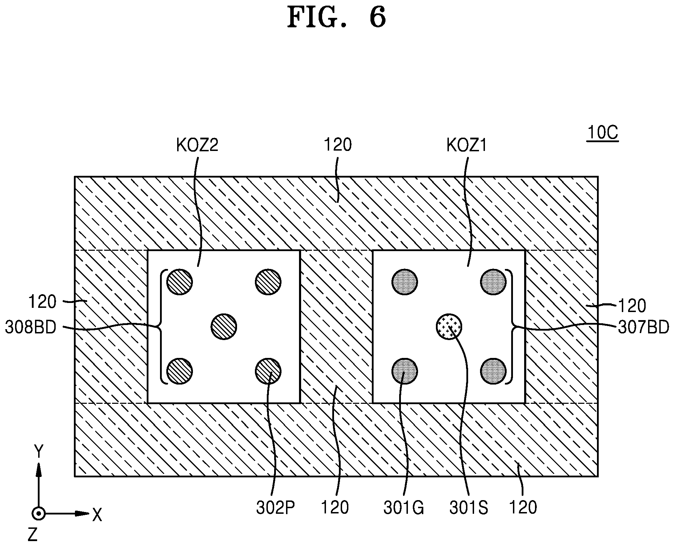

Referring to FIG. 6, a semiconductor chip 10C, according to an embodiment, may include the first through via structures 301 as a seventh bundle 307BD and include the second through via structures 302 as an eighth bundle 308BD.

As shown in FIG. 6, the plurality of first through via structures 301 may be configured as the signal transfer via structures 301S and/or the ground via structures 301G in the seventh bundle 307BD of the semiconductor chip 10C. Alternatively or additionally, the plurality of second through via structures 302 may be configured as the power transmission via structures 302P in the eighth bundle 308BD. In an embodiment, the second through via structure 302 may be spaced apart from the first through via structure 301.

The seventh bundle 307BD may be formed in the first keep out zone KOZ1 located on one side of the integrated circuit layer 120. As shown in FIG. 6, the arrangement of the plurality of first through via structures 301 included in the seventh bundle 307BD may be and/or may include an X-shaped structure. However, the present disclosure is not limited thereto. For example, according to some embodiments, a signal transfer via structures 301S may be arranged at the center, and the ground via structures 301G may be arranged at the corners of the signal transfer via structures 301S.

In an embodiment, the eighth bundle 308BD may be formed in the second keep out zone KOZ2 that may be located on the other side of the integrated circuit layer 120 (e.g., opposite to first keep out zone KOZ1). The size of the area of the second keep out zone KOZ2 may be substantially similar and/or may be the same as the size of the area of the first keep out zone KOZ1. As shown in FIG. 6, the arrangement of the plurality of second through via structures 302 included in the eighth bundle 308BD may be and/or may include an X-shaped structure. However, the present disclosure is not limited thereto. For example, according to some embodiments, the second through via structures 302 arranged in the second keep out zone KOZ2 may be the power transmission via structures 302P.

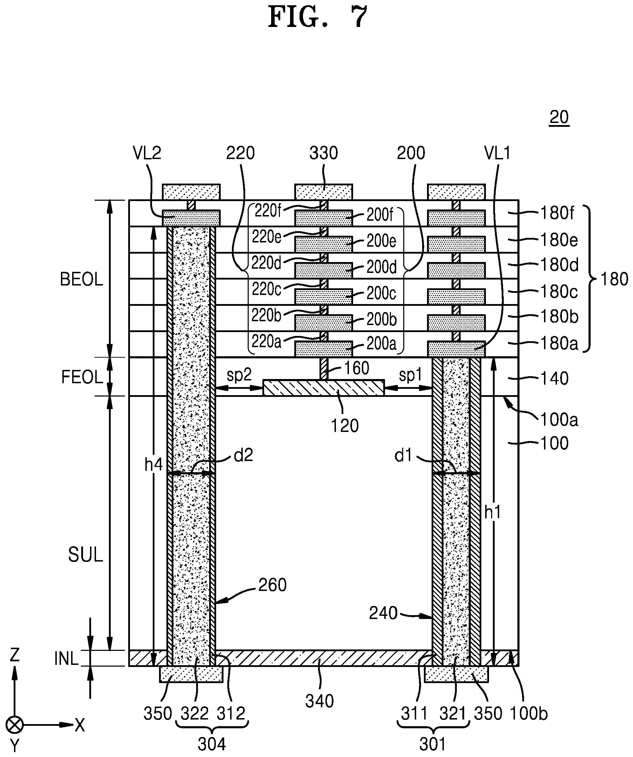

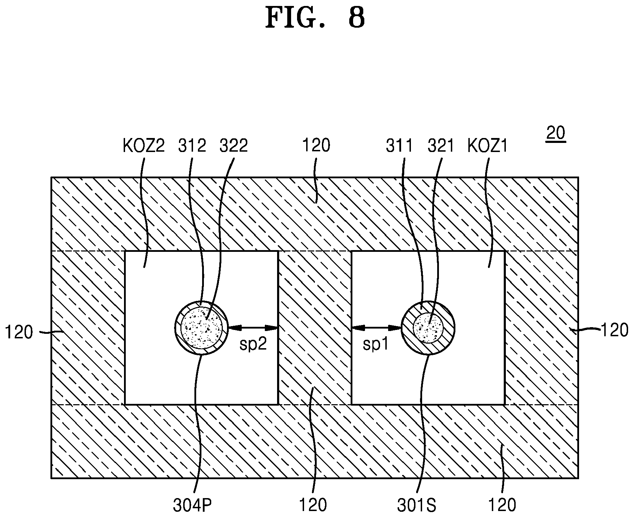

FIGS. 7 to 9 are diagrams showing a semiconductor chip, according to various embodiments. For example, FIG. 8 is a plan view for describing the arrangement relationship of the through via structure of FIG. 7, according to an embodiment.

Semiconductor chips 20 and 30 of FIGS. 7 to 9 may include and/or may be similar in many respects to at least one of the semiconductor device 10 described above with reference to FIGS. 1 to 3, and may include additional features not mentioned above. Therefore, repeated descriptions of components and/or elements of the semiconductor chip 10 described above may be omitted for the sake of simplicity and brevity.

Referring to FIGS. 7 and 8 together, a semiconductor chip 20, according to an embodiment, may be different from the semiconductor chip 10 described above with respect to the numbers of the first through via structures 301 and second through via structures 304 and a second vertical length h4 of a second through via structure 304, for example.

As shown in FIG. 7, the semiconductor chip 20 may include the first through via structure 301 and the second through via structure 304. The second through via structure 304 may extend in a vertical direction toward the semiconductor substrate 100 from a second via connection level VL2, which may correspond to any one of second to sixth metal wiring layers 200b to 200f. Alternatively or additionally, the second through via structure 304 may penetrate through the semiconductor substrate 100. According to some embodiments, the second via connection level VL2 may correspond to the sixth metal wiring layer 200f.

As shown in FIGS. 7 and 8, the first through via structure 301 may be formed as a single structure in the first keep out zone KOZ1 that may be located on one side of the integrated circuit layer 120 without forming a bundle. Alternatively or additionally, the second through via structure 304 may be formed as a single structure in the second keep out zone KOZ2 that may be located on the other side of the integrated circuit layer 120 (e.g., opposite to first keep out zone KOZ 1) without forming a bundle.

As such, in the semiconductor chip 20, the resistance of the second through via structure 304 may be lowered and/or adjusted to a desired value by adjusting the second vertical length h4 of the second through via structure 304. Alternatively or additionally, the semiconductor chip 20 may adjust the numbers of first through via structures 301 and second through via structures 304 in the first keep out zone KOZ 1 and the second keep out zone KOZ2.

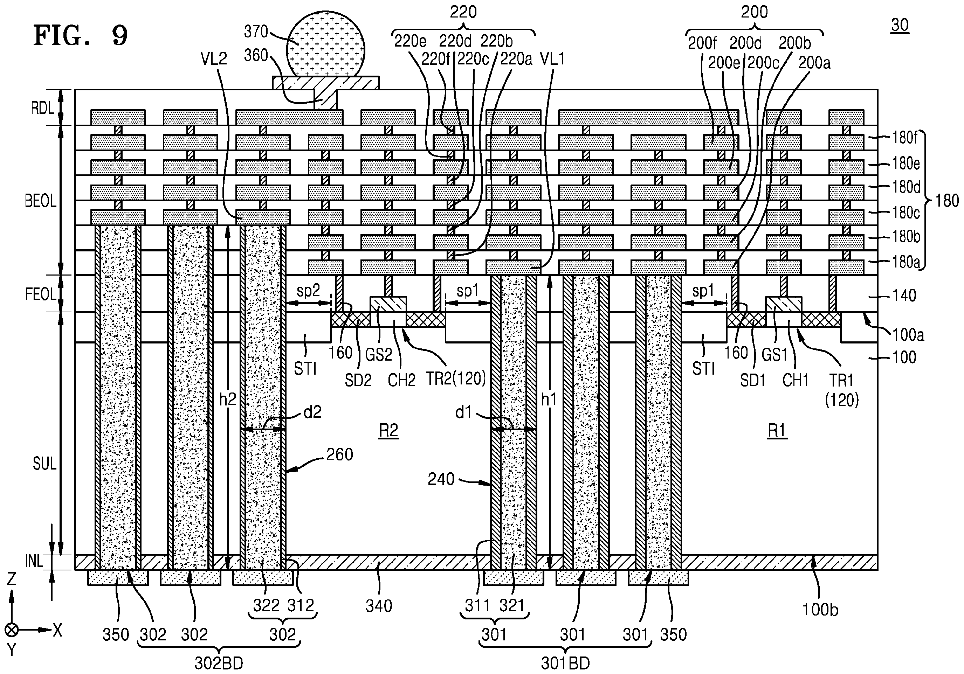

Referring to FIG. 9, compared to the semiconductor chip 10 described with reference to FIGS. 1 to 3, a semiconductor chip 30, according to an embodiment may include a first transistor TR1 and a second transistor TR2 that may be and/or may include the integrated circuit layer 120.

In an embodiment, the semiconductor chip 30 may include the first transistor TR1 and the second transistor TR2 constituting the integrated circuit layer 120. For example, the first transistor TR1 may be and/or may include an n-type transistor, and the second transistor TR2 may be and/or may include a p-type transistor.

In an embodiment, the first transistor TR1 may be formed in a first portion R1 of the semiconductor substrate 100 that may be defined by a device isolation region STI. For example, the device isolation region STI may be shallow trench isolation. In an embodiment, the device isolation region STI may be and/or may include an insulation layer. In an optional or additional embodiment, the first transistor TR1 may include a first channel region CH1, first source/drain regions SD1 positioned on both sides of the first channel region CH1, and a first gate structure GS1 formed on the first channel region CH1. The first source/drain region SD1 and the first gate structure GS1 may be electrically connected to the first metal wiring layer 200a through the contact plug layer 160.

In an embodiment, the second transistor TR2 may be positioned apart from the first transistor TR1 by a certain distance. For example, the second transistor TR2 may be formed in a second portion R2 of the semiconductor substrate 100 that may be defined by the device isolation region STI. In an optional or additional embodiment, the second transistor TR2 may include a second channel region CH2, second source/drain regions SD2 positioned on both sides of the second channel region CH2, and a second gate structure GS2 formed on the second channel region CH2. The second source/drain region SD2 and the second gate structure GS2 may be electrically connected to the first metal wiring layer 200a through the contact plug layer 160.

The semiconductor chip 30, according to an embodiment, may include the first bundle 301BD including the plurality of first through via structures 301 and the second bundle 302BD including the plurality of second through via structures 302. As shown in FIG. 9, the first bundle 301BD may be formed between the first transistor TR1 and the second transistor TR2. Alternatively or additionally, the second bundle 302BD may be formed around (e.g. beyond) the second transistor TR2, but the present disclosure is not limited thereto.

In the semiconductor chip 30, according to an embodiment, a redistribution level layer RDL may be further formed on the back end level layer BEOL on the semiconductor substrate 100. Alternatively or additionally, a bump pad 360 may be formed, which may penetrate through the redistribution level layer RDL and/or may be electrically connected to the redistribution level layer RDL. In an embodiment, a solder bump 370, which may be and/or may include an external connection terminal, may be formed on the bump pad 360. Therefore, wiring configurations of the semiconductor chip 30 may be increased by using the redistribution level layer RDL.

In an embodiment, the first transistor TR1 and the second transistor TR2 of the semiconductor chip 30 that may constitute the integrated circuit layer 120 may be formed on the semiconductor substrate 100. Alternatively or additionally, the first bundle 301BD of the plurality of first through via structures 301 and the second bundle 302BD of the plurality of second through via structures 302 may be formed around the first transistor TR1 and the second transistor TR2.

The semiconductor chip 30, according to embodiment, may have via insulation layers 311 and 312 having different thicknesses. Consequently, the resistance of the semiconductor chip 30 may be adjusted by using the first through via structures 301 connected to the lowermost portion of the back end level layer BEOL and/or the second through via structures 302 connected to the middle portion of the back end level layer BEOL.

Furthermore, the semiconductor chip 30, according to an embodiment, may potentially reduce and/or may prevent performance deterioration of the integrated circuit layer 120 by using the first bundle 301BD of the plurality of first through via structures 301 and the second bundle 302BD of the plurality of second through via structures 302 in the first keep out zone KOZ1 and the second keep out zone KOZ2.

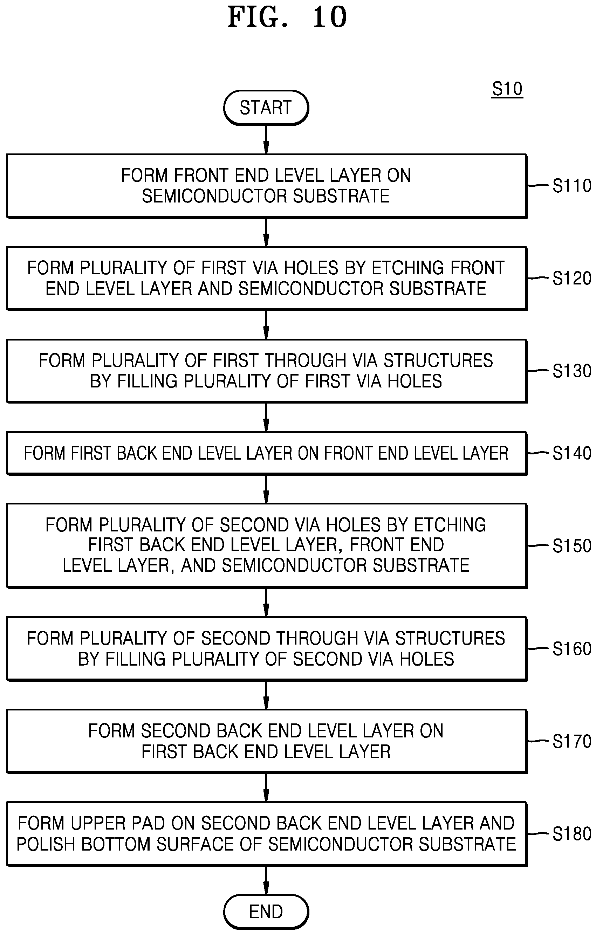

FIG. 10 is a flowchart showing a method of manufacturing a semiconductor chip, according to an embodiment.

Referring to FIG. 10, a method S10 of manufacturing a semiconductor chip may include operations S110 to S180.

In an embodiment that may be implemented otherwise, particular operations may be performed in an order different from that described below. For example, two successively described operations may be performed substantially and simultaneously and/or may be performed in an order opposite to the order described below.

The method S10 of manufacturing a semiconductor chip, according to the present disclosure, may include a first operation S 110 of forming a front end level layer on a semiconductor substrate, a second operation S120 of forming a plurality of first via holes by etching the front end level layer and the semiconductor substrate, a third operation S130 of forming a plurality of first through via structures by filling the plurality of first via holes, a fourth operation S140 of forming a first back end level layer on the front end level layer, a fifth operation S150 of forming a plurality of second via holes by etching the first back end level layer, the front end level layer, and the semiconductor substrate, a sixth operation S160 of forming a plurality of second through via structures by filling the plurality of second via holes, a seventh operation S 170 of forming a second back end level layer on the first back end level layer, and an eighth operation S 180 of forming an upper pad on the second back end level layer and polishing the bottom surface of the semiconductor substrate.

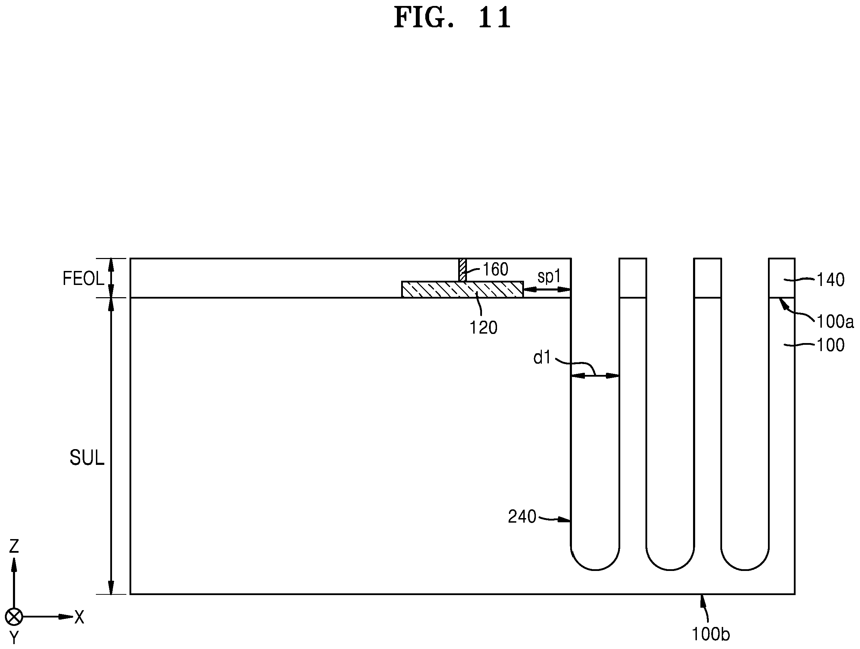

The technical features of first to eighth operations S110 to S180 are described with reference to FIGS. 11 to 16.

FIGS. 11 to 16 are cross-sectional views showing a method of manufacturing a semiconductor chip according to a process sequence, according to an embodiment.

Referring to FIG. 11, the semiconductor substrate 100 having the first surface 100a and the second surface 100b opposite to the first surface 100a may be prepared.

The integrated circuit layer 120 may be formed on the first surface 100a of the semiconductor substrate 100. The integrated circuit layer 120 may include circuit elements such as, but not limited to, transistors, capacitors, and resistors. In an embodiment, the semiconductor substrate 100 may be and/or may include a substrate level layer SUL.

The interlayer insulation layer 140 may be formed on the semiconductor substrate 100 and the integrated circuit layer 120. The interlayer insulation layer 140 may include a semiconductor material, such as, but not limited to, silicon oxide (SiO) and silicon nitride (SiN). A contact plug layer 160, which may be formed in the interlayer insulation layer 140, may be electrically connected to the integrated circuit layer 120. The contact plug layer 160 may be and/or may include, a metal layer, such as, but not limited to, a tungsten (W) layer. In an embodiment, the integrated circuit layer 120, the interlayer insulation layer 140, and the contact plug layer 160 formed on the semiconductor substrate 100 may constitute the front end level layer FEOL.

In an embodiment, a plurality of first via holes 240 may be formed by selectively etching the interlayer insulation layer 140 and the semiconductor substrate 100. For example, the plurality of first via holes 240 may be formed through a photolithography and/or an etching process. In an embodiment, the plurality of first via holes 240 may each be formed to have the first diameter d1. In an optional or additional embodiment, the plurality of first via holes 240 may be formed at one side of the integrated circuit layer 120 at the first separation distance sp1.

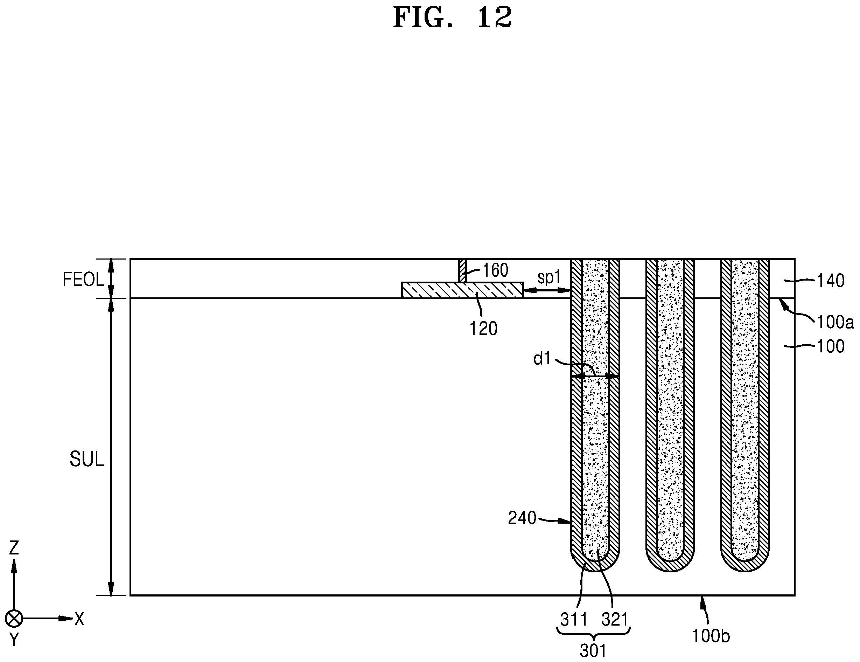

Referring to FIG. 12, the first via insulation layer 311 may be formed on the inner wall of each of the plurality of first via holes 240. The first via insulation layer 311 may include a semiconductor material, such as, but not limited to, silicon oxide (SiO) and silicon nitride (SiN). The first via electrode 321 filling the first via hole 240 may be formed on the first via insulation layer 311.

In an embodiment, a first via barrier layer may be formed between the first via insulation layer 311 and the first via electrode 321. The first via electrode 321 may be and/or may include a metal layer such as, but not limited to, a copper (Cu) layer, an aluminum (Al) layer, and a tungsten (W) layer. Through the manufacturing process described herein, the plurality of first through via structures 301 may be formed, in which each first through via structure 301 may include the first via insulation layer 311 and the first via electrode 321.

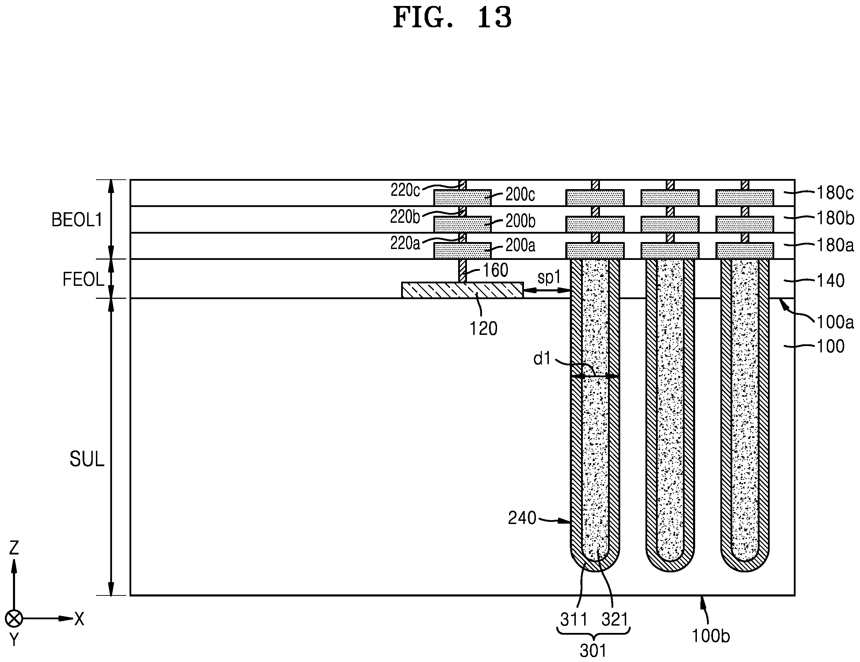

Referring to FIG. 13, a first back end level layer BEOL1 may be formed on the front end level layer FEOL.

In an embodiment, the first back end level layer BEOL1 may include first to third metal wiring layers 200a, 200b, and 200c, first to third wiring insulation layers 180a, 180b, and 180c, and first to third wiring via layers 220a, 220b, and 220c. First and second wiring via layers 220a and 220b may electrically interconnect the first to third metal wiring layers 200a, 200b and 200c. The first metal wiring layer 200a may be formed to be electrically connected to the contact plug layer 160.

In an embodiment, the first to third metal wiring layers 200a, 200b, and 200c may each be and/or include a metal layer, such as, but not limited to, a copper (Cu) layer, an aluminum (Al) layer, and a tungsten (W) layer. The first to third wiring insulation layers 180a, 180b, and 180c may include a semiconductor material, such as, but not limited to, silicon oxide (SiO) and silicon nitride (SiN). The first to third wiring via layers 220a, 220b, and 220c may each be and/or may include a metal layer, such as, but not limited to, a copper (Cu) layer, an aluminum (Al) layer, and a tungsten (W) layer.

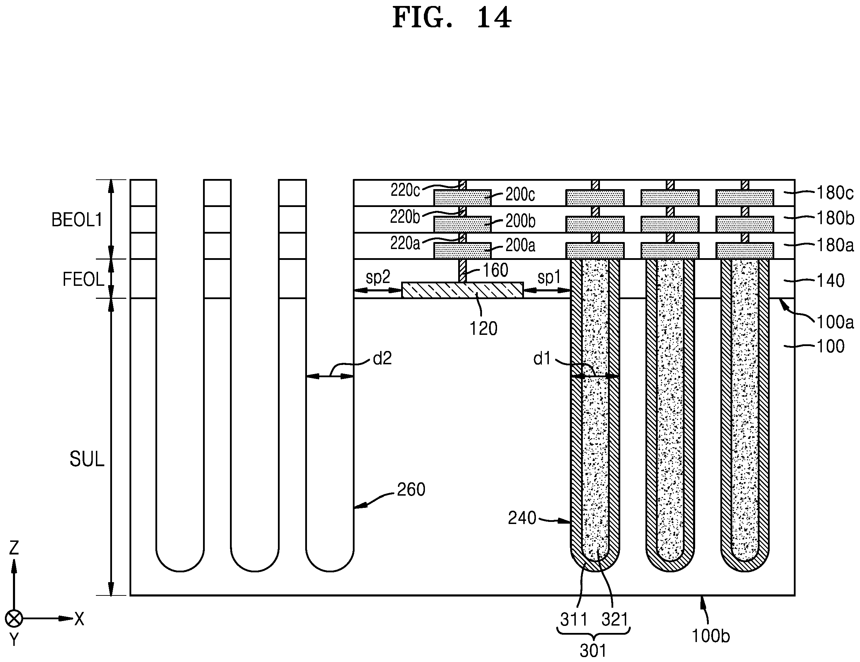

Referring to FIG. 14, a plurality of second via holes 260 may be formed by selectively etching the first to third wiring insulation layers 180a, 180b, and 180c, the interlayer insulation layer 140, and the semiconductor substrate 100.

In an embodiment, the plurality of second via holes 260 may be formed through a photolithography and/or an etching process. The plurality of second via holes 260 may each be formed to have a second diameter d2 that may be substantially similar and/or may be equal to the first diameter d1. Alternatively or additionally, the plurality of second via holes 260 may be formed on the other side of the integrated circuit layer 120 at the second separation distance sp2.

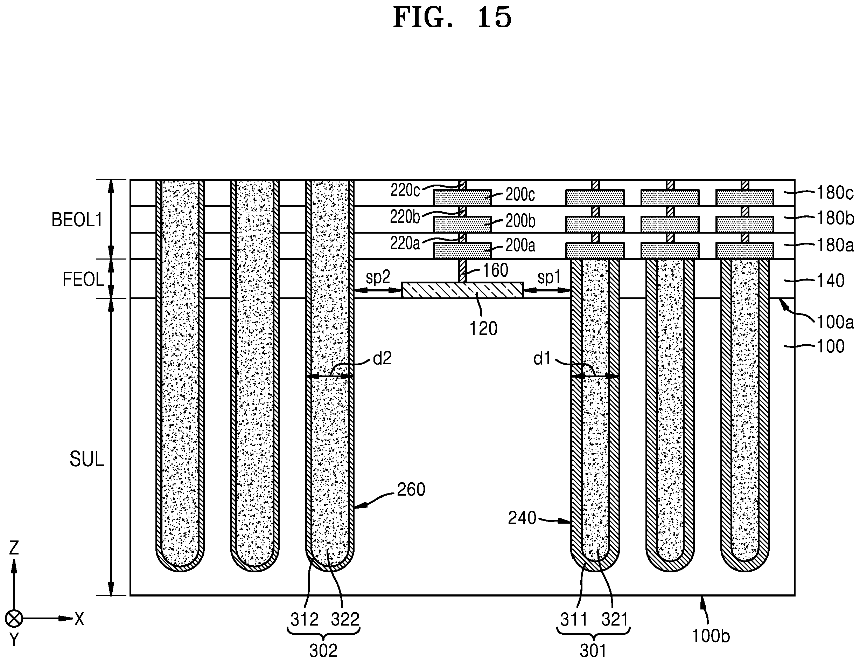

Referring to FIG. 15, the second via insulation layer 312 may be formed on the inner wall of each of the plurality of second via holes 260.

The second via insulation layer 312 may include a semiconductor material such as, but not be limited to, silicon oxide (SiO) and silicon nitride (SiN). In an embodiment, the second via electrode 322 filling the second via hole 260 may be formed on the second via insulation layer 312.

In an embodiment, a second via barrier layer may be formed between the second via insulation layer 312 and the second via electrode 322. The second via electrode 322 may be and/or may include a metal layer, such as, but not limited to, a copper (Cu) layer, an aluminum (Al) layer, and a tungsten (W) layer. In an optional or additional embodiment, the thickness of the second via insulation layer 312 may be smaller (e.g., narrower) than the thickness of the first via insulation layer 311. Through the manufacturing process described herein, the plurality of second through via structures 302 may be formed, in which each second through via structure 302 may include the second via insulation layer 312 and the second via electrode 322.

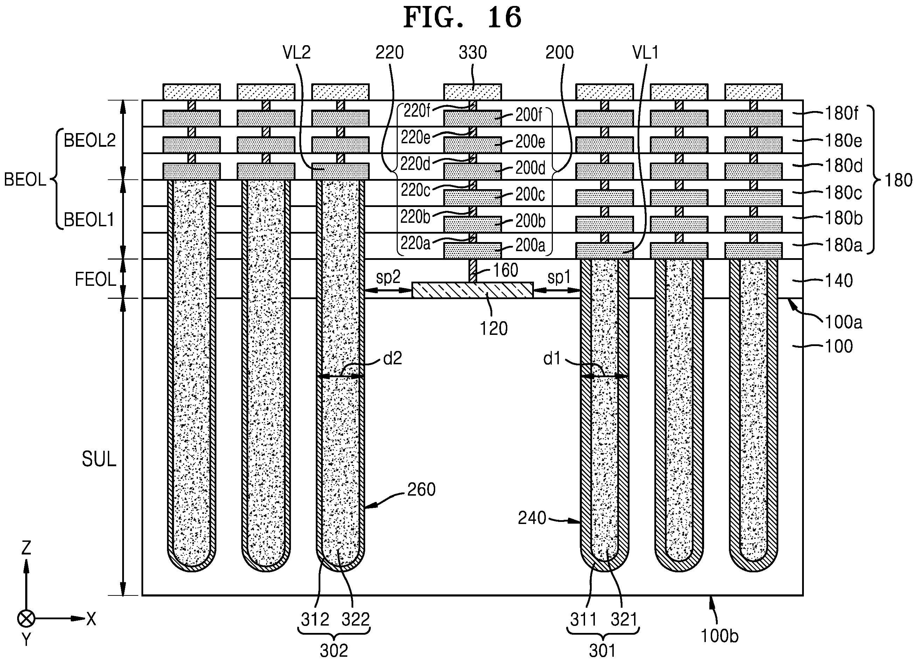

Referring to FIG. 16, a second back end level layer BEOL2 may be formed on the first back end level layer BEOL1.

In an embodiment, the second back end level layer BEOL2 may include fourth to sixth metal wiring layers 200d, 200e, and 200f, fourth to sixth wiring insulation layers 180d, 180e, and 180f, and fourth to sixth wiring via layers 220d, 220e, and 200f. The fourth and fifth wiring via layers 220d and 220e may electrically interconnect the fourth to sixth metal wiring layers 200d, 200e, and 200f. Alternatively or additionally, the fourth metal wiring layer 200d may be formed to be electrically connected to the third wiring via layer 220c.

The fourth to sixth metal wiring layers 200d, 200e, and 200f may be and/or may include a metal layer, such as, but not limited to, a copper (Cu) layer, an aluminum (Al) layer, and a tungsten (W) layer. The fourth to sixth wiring insulation layers 180d, 180e, and 180f may include a semiconductor material, such as, but not limited to, silicon oxide (SiO) and silicon nitride (SiN). The fourth to sixth wiring via layers 220d, 220e, and 200f may be and/or may include a metal layer, such as, but not limited to, a copper (Cu) layer, an aluminum (Al) layer, and a tungsten (W) layer.

From among the fourth to sixth metal wiring layers 200d, 200e, and 200f constituting the second back end level layer BEOL2, the fourth metal wiring layer 200d may be formed on the second through via structure 302 and/or may become the second via connection level VL2. In an embodiment, the vertical level of the second via connection level VL2 may be different from the vertical level of the first via connection level VL1.

Through the manufacturing process as described herein, the back end level layer BEOL may include the first back end level layer BEOL1 and the second back end level layer BEOL2. In an embodiment, the back end level layer BEOL may include the metal wiring layers 200, the wiring insulation layers 180, and the wiring via layers 220. The metal wiring layers 200 may include first to sixth metal wiring layers 200a to 200f. The wiring insulation layers 180 may include first to sixth wiring insulation layers 180a to 180f. The wiring via layers 220 may include first to sixth wiring via layers 220a to 220f.

Referring to FIG. 1, the upper pad 330 may be formed on the sixth wiring via layer 220f. For example, a polishing process may be performed on the second surface 100b of the semiconductor substrate 100, as needed. In an embodiment, the polishing process may be a chemical mechanical polishing (CMP) process and/or an etch-back process. The plurality of first through via structures 301 and the plurality of second through via structures 302 may be exposed through the polishing process. Alternatively or additionally, the lower protective insulation layer 340 and the lower pad 350 may be formed on the second surface 100b of the semiconductor substrate 100, as needed.

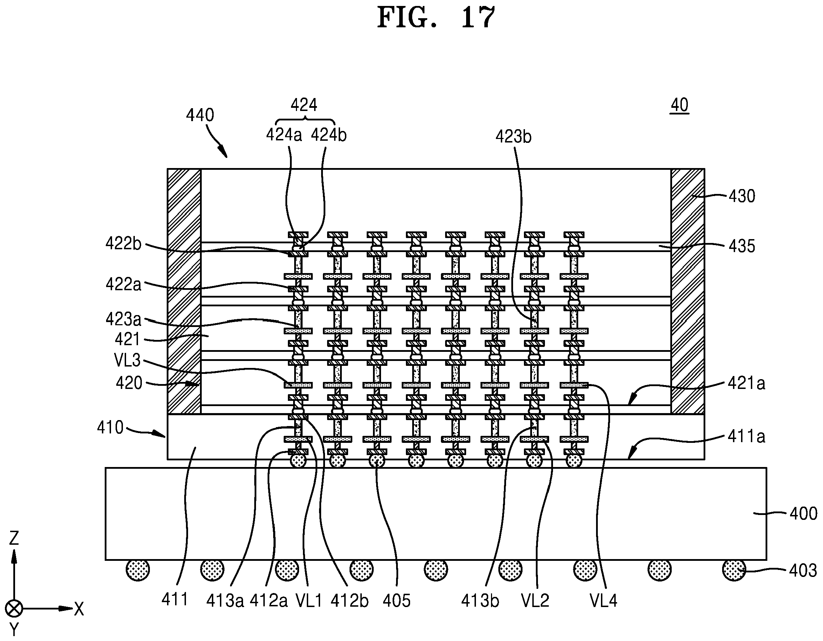

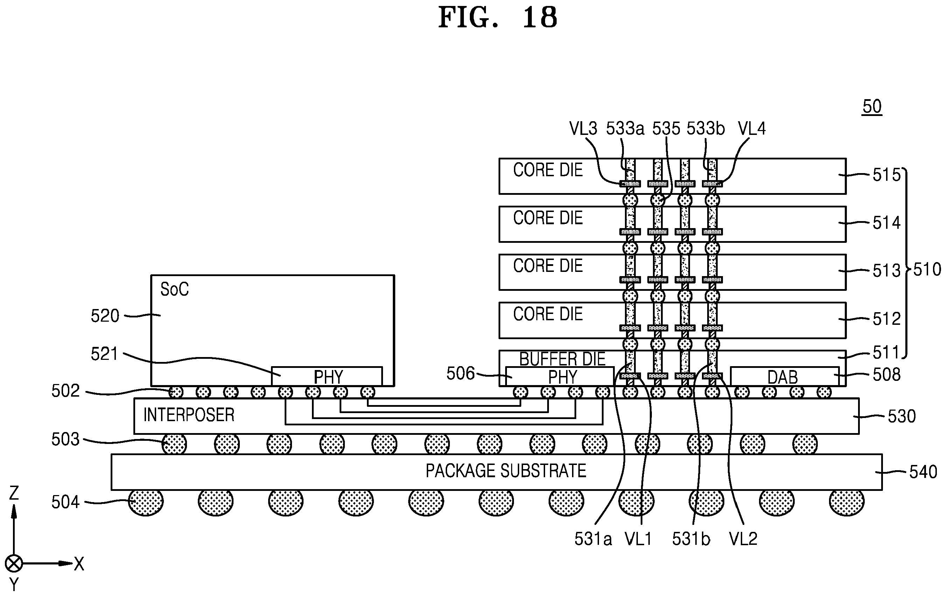

FIGS. 17 and 18 are block diagrams showing semiconductor packages including semiconductor chips, according to various embodiments.

Referring to FIG. 17, a semiconductor package 40 may include a stacked semiconductor chip 440 mounted on a package substrate 400.

In an embodiment, the package substrate 400 may be and/or may include a printed circuit board. Solder bumps 403, which may be external connection terminals, may be formed on the bottom surface of the package substrate 400.

The stacked semiconductor chip 440 may include a first semiconductor chip 410 and a second semiconductor chips 420 mounted on the first semiconductor chip 410. The second semiconductor chips 420 may be sequentially stacked on the first semiconductor chip 410 in a vertical direction (e.g., a Z direction). The width of the first semiconductor chip 410 may be greater (e.g., wider) than the width of each of the second semiconductor chips 420.

Although FIG. 17 shows that the stacked semiconductor chip 440 includes four (4) second semiconductor chips 420, the present disclosure is not limited thereto. For example the first semiconductor chip 410 and the second semiconductor chips 420 may include semiconductor chips 10, 20, and 30, according to the embodiments described with reference to FIGS. 1 to 9.

For example, the first semiconductor chip 410 may include a first pad 412a and a second pad 412b on both surfaces of a first semiconductor substrate 411. The first pad 412a and the second pad 412b may be electrically connected to each other by a first through via structure 413a, the first via connection level VL1, a second through via structure 413b, and/or the second via connection level VL2.

The first through via structure 413a may be electrically connected to the first via connection level VL1. The second through via structure 413b may be electrically connected to the second via connection level VL2. Although the vertical levels of the first via connection level VL1 are shown in FIG. 17 as being substantially similar to and/or the same as the vertical levels of the second via connection level VL2 for convenience of illustration, the present disclosure is not limited in this regard. For example, the vertical levels of the first via connection level VL1 may be different from the vertical levels of the second via connection level VL2.

The first pad 412a may be electrically connected to the package substrate 400 through a solder bump 405, which may be an external connection terminal. In an embodiment, an active surface 411a of the first semiconductor chip 410 may be positioned downward. For example, the first pad 412a may be and/or may include an upper pad, and the second pad 412b may be and/or may include a lower pad.

In an embodiment, each of the second semiconductor chips 420 may include a third pad 422a and a fourth pad 422b on both surfaces of a second semiconductor substrate 411. For example, the third pad 422a and the fourth pad 422b may be electrically connected to each other by a third through via structure 423a, a third via connection level VL3, a fourth through via structure 423b, and/or a fourth via connection level VL4.

In an embodiment, the third through via structure 423a may be electrically connected to the third via connection level VL3. Alternatively or additionally, the fourth through via structure 423b may be electrically connected to the fourth via connection level VL4. Although the vertical levels of the third via connection level VL3 are shown in FIG. 17 as being substantially similar to and/or the same as the vertical levels of the fourth via connection level VL4 for convenience of illustration, the present disclosure is not limited in this regard. For example, the vertical levels of the third via connection level VL3 may be different from the vertical levels the fourth via connection level VL4.

In an embodiment, the third pad 422a may electrically interconnect the second semiconductor chips 420 through an internal connection terminal 424. Alternatively or additionally, the internal connection terminal 424 may include an internal connection pad 424a and an internal bump 424b.

In an embodiment, an active surface 421a of each of the second semiconductor chips 420 may be positioned downward. For example, the third pad 422a may be referred to as an upper pad, and the fourth pad 422b may be referred to as a lower pad. In the stacked semiconductor chip 440, the second semiconductor chips 420 may be adhered to each other by an adhesive layer 435. Alternatively or additionally, the second semiconductor chips 420 may be molded on the first semiconductor chip 410 by a molding layer 430.

Referring to FIG. 18, a semiconductor package 50 may include a stacked memory device 510, a system-on-chip (SoC) 520, an interposer 530, and a package substrate 540.

The stacked memory device 510 may include a buffer die 511 and core dies (e.g., first core die 512, second core die 513, third core die 514, and fourth core die 515). The core dies 512 to 515 may each include a plurality of memory cells configured to store data (e.g., instructions, commands, data values, and the like). As shown in FIG. 18, the buffer die 511 may include a first physical layer (PHY) 506 and a direct access region (DAB) 508. In an embodiment, the first PHY 506 may be electrically connected to a second PHY 521 of the system-on-chip 520 through the interposer 530. In an optional or additional embodiment, the stacked memory device 510 may receive a signal from the system-on-chip 520 and/or transmit a signal to the system-on-chip 520 through the first PHY 506.

In an embodiment, the DAB 508 may provide an access path through which the stacked memory device 510 may be tested without using the system-on-chip 520. For example, the DAB 508 may include conductive means capable of directly communicating with an external test device. A test signal received through the DAB 508 may be transmitted to the core dies 512 to 515 using through via structures. For example, testing of the core dies 512 to 515 may include transmitting data read from the core dies 512 to 515 to a test device through the through via structures and/or the DAB 508. Accordingly, a direct access test for the core dies 512 to 515 may be performed.

In an embodiment, the buffer die 511 and the core dies 512 to 515 may be electrically connected to each other using through via structures (e.g., first through via structure 531a, second through via structure 531b, third through via structure 533a, and fourth through via structure 533b) and bumps 535. In an optional or additional embodiment, the buffer die 511 and the core dies 512 to 515 may include the semiconductor chips 10, 20, and 30 according to the embodiments described with reference to FIGS. 1 to 9.

For example, the buffer die 511 may include a first through via structure 531a, the first via connection level VL1, a second through via structure 531b, and the second via connection level VL2. The first through via structure 531a may be electrically connected to the first via connection level VL1. The second through via structure 531b may be electrically connected to the second via connection level VL2. Although the vertical levels of the first via connection level VL1 are shown in FIG. 18 as being substantially similar and/or the same as the vertical levels of the second via connection level VL2 for convenience of illustration, the present disclosure is not limited in this regard. For example, the vertical levels of the first via connection level VL1 may be different from the vertical levels of the second via connection level VL2.

The core dies 512 to 515 may each include a third through via structure 533a, the third via connection level VL3, a fourth through via structure 533b, and the fourth via connection level VL4. The third through via structure 533a may be electrically connected to the third via connection level VL3. The fourth through via structure 533b may be electrically connected to the fourth via connection level VL4. Although the vertical levels of the third via connection level VL3 are shown in FIG. 18 as being substantially similar and/or the same as the vertical levels of the fourth via connection level VL4 for convenience of illustration, the present disclosure is not limited in this regard. For example, the vertical levels of the third via connection level VL3 may be different from the vertical levels of the fourth via connection level VL4.

In an embodiment, the buffer die 511 may receive signals provided to respective channels from the system-on-chip 520 through bumps 502 allocated for the respective channels and/or may transmit signals through the bumps 502 to the system-on-chip 520. For example, the bumps 502 may be and/or may include micro bumps.

The system-on-chip 520 may execute applications supported by the semiconductor package 50 by using the stacked memory device 510. Alternatively or additionally, the system-on-chip 520 may control overall operations of the stacked memory device 510. In an embodiment, the system-on-chip 520 may include the second PHY 521. The second PHY 521 may include an interface circuit for transmitting and/or receiving signals to and/or from the first PHY 506 of the stacked memory device 510. For example, the system-on-chip 520 may provide various signals to the first PHY 506 through the second PHY 521. Signals provided to the first PHY 506 may be transferred to the core dies 512 to 515 through the interface circuit of the first PHY 506 and the first to fourth through via structures 531a, 531b, 533a, and 533b.

In an embodiment, the interposer 530 may interconnect the stacked memory device 510 and the system-on-chip 520. The interposer 530 may interconnect the first PHY 506 of the stacked memory device 510 and the second PHY 521 of the system-on-chip 520. Alternatively or additionally, the interposer 530 may provide a physical path formed using a conductive material. That is, the stacked memory device 510 and the system-on-chip 520 may be stacked on the interposer 530 and exchange signals with each other.

In an embodiment, bumps 503 may be attached to an upper portion of the package substrate 540. Alternatively or additionally, solder balls 504 may be attached to a lower portion of the package substrate 540. For example, the bumps 503 may be and/or may include flip-chip bumps. The interposer 530 may be stacked on the package substrate 540 through the bumps 503. The semiconductor package 50 may transmit and/or receive signals to and/or from other external packages and/or external electronic devices through the solder balls 504. For example, the package substrate 540 may be and/or may include a printed circuit board.

While the present disclosure has been particularly shown and described with reference to embodiments thereof, it may be understood that various changes in form and details may be made therein without departing from the scope of the following claims.

## Claims

1. A semiconductor chip, comprising:
a semiconductor substrate;
an integrated circuit layer formed on the semiconductor substrate;
a plurality of metal wiring layers sequentially formed on the semiconductor substrate and the integrated circuit layer;
a first through via structure bundle extending in a vertical direction from a first metal wiring layer of the plurality of metal wiring layers toward the semiconductor substrate and penetrating through the semiconductor substrate; and
a second through via structure bundle spaced apart from the first through via structure bundle, extending in the vertical direction from a second metal wiring layer of the plurality of metal wiring layers toward the semiconductor substrate, and penetrating through the semiconductor substrate.

2. The semiconductor chip of claim 1, wherein a first diameter of each of first through via structures comprised by the first through via structure bundle is substantially equal to a second diameter of each of second through via structures comprised by the second through via structure bundle.

3. The semiconductor chip of claim 2, wherein:
each of the first through via structures comprises a first via electrode and a first via insulation layer surrounding the first via electrode,
each of the second through via structures comprises a second via electrode and a second via insulation layer surrounding the second via electrode, and
a first thickness of the first via insulation layer is greater than a second thickness of the second via insulation layer.

4. The semiconductor chip of claim 3, wherein a first length of each of the first through via structures in the vertical direction is smaller than a second length of each of the second through via structures in the vertical direction.

5. The semiconductor chip of any preceding claim, wherein:
the first through via structure bundle comprises a signal transfer via structure, and
the second through via structure bundle comprises a power transmission via structure.

6. The semiconductor chip of claim 5, wherein:
the signal transfer via structure is disposed at a center of the first through via structure bundle,
the first through via structure bundle comprises a plurality of ground via structures disposed around the signal transfer via structure, and
the second through via structure bundle comprises a plurality of power transmission via structures.

7. The semiconductor chip of claim 5, wherein:
the signal transfer via structure comprises a plurality of signal transfer via structures disposed in a first diagonal direction,
the first through via structure bundle comprises a plurality of ground via structures disposed in a second diagonal direction opposite to the first diagonal direction, and
the second through via structure bundle comprises a plurality of power transmission via structures.

8. The semiconductor chip of any preceding claim, wherein:
the first through via structure bundle and the second through via structure bundle are each surrounded by an insulation material.

9. The semiconductor chip of any preceding claim, wherein a first level of a bottom surface of a lowermost wiring layer from among the plurality of metal wiring layers is substantially equal to a second level of a top surface of the first through via structure bundle.

10. The semiconductor chip of claim 9, further comprising:
an upper pad electrically connected to an uppermost wiring layer from among the plurality of metal wiring layers, and disposed on the uppermost wiring layer, and
a lower pad electrically connected to the first through via structure bundle and the second through via structure bundle, and disposed on a bottom surface of the semiconductor substrate.

11. The semiconductor chip of any preceding claim, wherein:
the semiconductor substrate has a first surface and a second surface facing away from each other;
a front end level layer is formed on the first surface of the semiconductor substrate and comprises the integrated circuit layer;
a back end level layer is electrically connected to the integrated circuit layer on the front end level layer and comprises the plurality of metal wiring layers;
the first through via structure bundle penetrates through the front end level layer, the first surface of the semiconductor substrate, and the second surface of the semiconductor substrate; and
the second through via structure bundle penetrates through at least a part of the back end level layer, the front end level layer, the first surface of the semiconductor substrate, and the second surface of the semiconductor substrate.

12. The semiconductor chip of claim 11, wherein a first level of a first top surface of the front end level layer is substantially equal to a second level of a second top surface of the first through via structure bundle.

13. The semiconductor chip of any preceding claim, wherein a first number of via structures comprised by the first through via structure bundle is substantially equal to a second number of via structures comprised by the second through via structure bundle.
